# EUROPEAN PATENT APPLICATION

(11) **EP 1 492 169 A2**
(43) Date of publication of application: **29.12.2004**
(21) Application number: 04014934.6
(22) Date of filing: 25.06.2004
(51) Int. Cl.: H01L 31/0336, H01L 31/032

(54) **Solar cell**

(30) Priority: 26.06.2003 JP 2003183284
(71) Applicant: MATSUSHITA ELECTRIC INDUSTRIAL CO., LTD., Kadoma-shi, Osaka 571-8501 (JP)
(72) Inventor: Negami, Takayuki, Hirakata-shi Osaka 573-0164 (JP); Hashimoto, Yasuhiro, Soraku-gun Kyoto 619-0243 (JP)
(74) Representative: Schorr, Frank, Dr.

(57) **Abstract**

A CIS-based solar cell with a high conversion efficiency that has been reduced in cost by omitting a window layer is provided. A solar cell (10) includes: a first layer (1) having translucency and conductivity; and a p-type semiconductor layer (2) disposed adjacent to the first layer (1), with a junction being formed by the first layer (1) and the p-type semiconductor layer (2), wherein the p-type semiconductor layer (2) includes a semiconductor with a chalcopyrite structure containing a group Ib element, a group IIIb element and a group VIb element; the first layer (1) has a carrier density of 10¹⁹/cm³ or more, a band gap Eg₁ (eV) of the first layer (1) and a band gap Eg₂ (eV) of the p-type semiconductor layer (2) satisfy a relationship represented by the formula: Eg₁ > Eg₂, and an electron affinity χ₁ (eV) of the first layer (1) and an electron affinity χ₂ (eV) of the p-type semiconductor layer (2) satisfy a relationship represented by the formula: 0 ≤ (χ₂ - χ₁) < 0.5.

## Description

The present invention relates to solar cells.

It is known that thin-film solar cells using, as the light absorption layer, compound semiconductor thin films (semiconductor thin films with a chalcopyrite structure) containing group Ib elements, group IIIb elements and group VIb elements exhibit high energy conversion efficiency and have the advantage that they suffer no degradation of the conversion efficiency due to light irradiation and the like. Specifically, solar cells (CIS-based solar cells) are known, which use compound semiconductors (hereinafter, also referred to as "CIS-based semiconductors"), such as CuInSe₂ (hereinafter, also simply referred to as "CIS") and Cu(In, Ga)Se₂ (hereinafter, also simply referred to as "CIGS") in which Ga forms a solid solution in CIS, as the light absorption layer. Generally, these CIS-based solar cells include a transparent conductive layer (transparent electrode layer), a window layer, a light absorption layer (CIS-based semiconductor layer) and a back electrode layer, which are arranged in this order from the light incident side. Photovoltaic power is generated by light incident from the transparent conductive layer, which is the light incident side.

The window layer of a CIS-based solar cell usually is formed by an n-type semiconductor or a high resistivity material that is almost an insulator. Typical examples of the window layer used for CIS-based solar cells include a CdS film, a ZnO film and a ZnO-based Zn(O, OH, S) film. It has been considered that a junction is formed by the window layer and the CIS-based semiconductor layer, which is a p-type semiconductor layer. However, it seems that an actual junction is formed by the transparent conductive layer and the CIS-based semiconductor layer for the following reasons: When used as the window layer, the CdS film, which is an n-type semiconductor layer, and the ZnO film and the Zn(O, OH, S) film, which are high resistivity materials, have a low carrier density, (e.g., a film of about 10¹⁵/cm³ or less is used as the window layer, generally) and the window layer usually has a small thickness of 100 nm or less. It seems that the window layer forms an i-p junction with the CIS-based semiconductor layer and serves to reduce leakage due to a tunneling current that could occur when the transparent conductive layer and the CIS-based semiconductor layer are brought into a direct contact. If the window layer could be omitted, it would be possible to simplify the production process of solar cells and reduce the materials used therefor, realizing lower cost solar cells.

However, simply omitting the window layer from a solar cell will result in a leakage due to the tunneling current between the transparent conductive layer and the CIS-based semiconductor layer as described above, so that the solar cell cannot fulfill its functions.

It should be noted that a CdS film, which is a typical conventional window layer, is disclosed in, for example, Applied Physics Letters, vol.25, No.8, pp 434-435 (1974), Wagner et. al, "CuInSe₂/CdS Heterojunction Photovoltaic Detector". Similarly, a ZnO film is disclosed in, for example, JP H7-007167A, and a Zn(O, OH, S) film is disclosed in, for example, JP H8-330614A.

Therefore, with the foregoing in mind, it is an object of the present invention to provide a CIS-based solar cell with a high conversion efficiency that has been reduced in cost by omitting a window layer.

A solar cell according to the present invention includes: a first layer having translucency and conductivity; and a p-type semiconductor layer disposed adjacent to the first layer, with a junction being formed by the first layer and the p-type semiconductor layer, wherein the p-type semiconductor layer includes a semiconductor with a chalcopyrite structure containing a group Ib element, a group IIIb element and a group VIb element, the first layer has a carrier density of 10¹⁹/cm³ or more, a band gap Eg₁ (eV) of the first layer and a band gap Eg₂ (eV) of the p-type semiconductor layer satisfy a relationship represented by the formula: Eg₁ > Eg₂, and an electron affinity X₁ (eV) of the first layer and an electron affinity X₂ (eV) of the p-type semiconductor layer satisfy a relationship represented by the formula: 0 ≤ (X₂ - X₁) < 0.5.

Alternatively, a solar cell according to the present invention may be a solar cell that includes: a first layer having translucency and conductivity; an n-type semiconductor layer disposed adjacent to the first layer; and a p-type semiconductor layer disposed in such a manner that the n-type semiconductor layer is sandwiched between the p-type semiconductor layer and the first layer, with a junction being formed by the first layer, the n-type semiconductor layer and the p-type semiconductor layer, wherein the p-type semiconductor layer includes a semiconductor with a chalcopyrite structure containing a group Ib element, a group IIIb element and a group VIb element, the first layer has a carrier density of 10¹⁹/cm³ or more, a band gap Eg₁ (eV) of the first layer and a band gap Eg₃ (eV) of the n-type semiconductor layer satisfy a relationship represented by the formula: Eg₁ > Eg₃, an electron affinity X₁ (eV) of the first layer and an electron affinity X₃ (eV) of the n-type semiconductor layer satisfy a relationship represented by the formula: 0 ≤ (X₃ - X₁) < 0.5, a band gap Eg₂ (eV) of the p-type semiconductor layer is substantially equal to the Eg₃, and an electron affinity X₂ (eV) of the p-type semiconductor layer is substantially equal to the X₃.

Alternatively, a solar cell according to the present invention may be a solar cell that includes a first layer having translucency and conductivity, a semiconductor layer disposed adjacent to the first layer and a p-type semiconductor layer disposed in such a manner that the semiconductor layer is sandwiched between the p-type semiconductor layer and the first layer, with a junction being formed by the first layer, the semiconductor layer and the p-type semiconductor layer, wherein the p-type semiconductor layer includes a semiconductor with a chalcopyrite structure containing a group Ib element, a group IIIb element and a group VIb element, the first layer has a carrier density of 10¹⁹/cm³ or more, a band gap Eg₁ (eV) of the first layer and a band gap Eg₄ (eV) of the semiconductor layer satisfy a relationship represented by the formula: Eg₁ > Eg₄, an electron affinity X₁ (eV) of the first layer and an electron affinity X₄ (eV) of the semiconductor layer satisfy a relationship represented by the formula: 0 ≤ (X₄ - X₁) < 0.5, a band gap Eg₂ (eV) of the p-type semiconductor layer is substantially equal to the Eg₄, an electron affinity X₂ (eV) of the p-type semiconductor layer is substantially equal to the X₄, and a carrier density N₂ (cm⁻³) of the p-type semiconductor layer and a carrier density N₄ (cm⁻³) of the semiconductor layer satisfy a relationship represented by the formula: N₄ < N₂.

Any of the above-described solar cells can function as a CIS-based solar cell with a high conversion efficiency that has been reduced in cost.
FIG. 1 is a cross-sectional view schematically showing an example of a solar cell of the present invention.
FIG. 2A is a diagram showing an example of a band profile of the solar cell shown in FIG.1.
FIG. 2B is a diagram showing an example of a band profile of the solar cell shown in FIG.1.
FIG. 3 is a cross-sectional view schematically showing another example of a solar cell of the present invention.
FIG. 4 is a diagram showing an example of a band profile of the solar cell shown in FIG. 3.
FIG. 5 is a diagram showing yet another example of a solar cell of the present invention.
FIG. 6 is a diagram schematically showing an example of a band profile of the solar cell shown in FIG. 5.
FIG. 7 is a graph showing the relationship between the Ga content x of the group IIIb elements in a (In₁₋ₓGaₓ)₂O₃ film and the electron affinity difference between a (In₁₋ₓGaₓ)₂O₃ film and a CIGS film that were measured in the examples.
FIG. 8 is a graph showing the relationship between the Ga content x of the group IIIb elements in a (In₁₋ₓGaₓ)₂O₃ film and the conversion efficiency of the solar cell that were measured in the examples.
FIG. 9 is a graph showing the relationship between the thicknesses of a CIGS:Zn film and the conversion efficiency of the solar cell that were measured in the examples.

Embodiments of the present invention are described below with reference to the drawings. In the following embodiments, the same reference numerals are applied to the same components, and redundant explanations are thus omitted in some cases.

### Embodiment 1

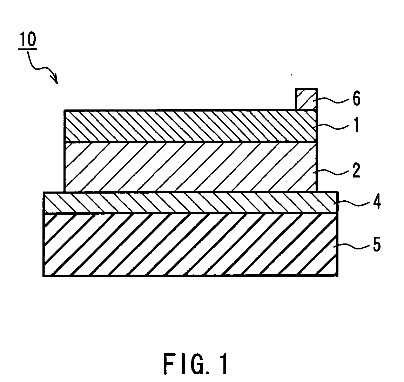

FIG. 1 shows an example of a solar cell of the present invention. A solar cell 10 shown in FIG. 1 includes a transparent conductive layer 1 (first layer) having translucency and conductivity, and a p-type semiconductor layer 2 disposed adjacent to the transparent conductive layer 1. The transparent conductive layer 1 is disposed at the light incident side, and the p-type semiconductor layer 2 is disposed adjacent to the back side of the transparent conductive layer 1 (the side opposite to the light incident side). A junction is formed by the transparent conductive layer 1 and the p-type semiconductor layer 2 (i.e., the junction necessary to obtain photovoltaic power is made up of the transparent conductive layer 1 and the p-type semiconductor layer 2), so that the solar cell 10 can generate photovoltaic power with light incident from the side of the transparent conductive layer 1.

The solar cell 10 shown in FIG. 1 also includes a lower electrode layer 4, a substrate 5 and an electrode 6. The lower electrode layer 4, the p-type semiconductor layer 2 and the transparent conductive layer 1 are arranged on the substrate 5 in this order. The electrode 6 is formed on the transparent conductive layer 1. The generated photovoltaic power can be retrieved via the lower electrode layer 4 and the electrode 6.

Here, the p-type semiconductor layer 2 is a layer serving as the light absorption layer. As the p-type semiconductor layer 2, for example, it is possible to use a thin film including a compound semiconductor that contains a group Ib element, a group IIIb element and a group VIb element and that has a crystal structure similar to chalcopyrite (chalcopyrite structure). Groups of elements in this specification are expressed in accordance with IUPAC (1970) standards. According to IUPAC (1989) standards, the group Ib element corresponds to a group 11 element, the group IIIb element corresponds to a group 13 element and the group VIb element corresponds to a group 16 element.

Specifically, a compound semiconductor thin film represented by the composition formula X¹X²X³₂ may be used, for example. In the formula, X¹ is a group Ib element, X² is a group IIIb element and X³ is a group VIb element. The group Ib element is not particularly limited, and Cu (copper) is particularly preferable. The group IIIb element is not particularly limited, and at least one selected from the group consisting of In (indium) and Ga (gallium) is particularly preferable. The group VIb element is not particularly limited, and at least one selected from the group consisting of Se (selenium) and S (sulfur) is preferable. More specifically, for example, CuInSe₂ (CIS), Cu(In, Ga)Se₂ (CIGS) or a compound semiconductor thin film in which Se in these compounds is partially replaced by S (sulfur) can be used. Thus, it is possible to produce a solar cell with excellent power generation characteristics such as conversion efficiency.

Such a p-type semiconductor layer 2 can be produced by using, for example, any common method of producing a light absorption layer in the production method of CIS-based solar cells. Specifically, it is possible to use, for example, a method in which a thin film made of a group Ib element and a group IIIb element that has been formed by sputtering or the like is heat-treated under an atmosphere of a group VIb element. The p-type semiconductor layer 2 also can be formed, for example, by electrodeposition, vapor deposition (e.g., multisource vapor deposition) or sputtering (e.g., sputtering in which a plurality of targets with different compositions are arranged). The method of forming the p-type semiconductor layer 2 is not limited to the above examples, and any method that can realize the above-described configuration of the p-type semiconductor layer 2 can be used without any particular limitation.

The thickness of the p-type semiconductor layer 2 is not particularly limited, and may be in the range from 0.4 µm to 3.5 µm, for example.

The transparent conductive layer 1 has translucency and conductivity. "Translucency" as described herein may be the translucency with respect to light within a band that is incident on the solar cell 10. The carrier density of the transparent conductive layer 1 is 10¹⁹/cm³ or more. Accordingly, a junction can be formed by the transparent conductive layer 1 and the p-type semiconductor layer 2. Preferably, the transparent conductive layer 1 is an n-type layer. A p-n junction can be formed by the transparent conductive layer 1 and the p-type semiconductor layer 2. Since a window layer, which has been necessary for conventional solar cells, has a far lower carrier density (e.g., 10¹⁵/cm³ or less) as described above, the transparent conductive layer 1 in a solar cell of the present invention is a layer completely different from the conventional window layer.

The band gap Eg₁ (eV) of the transparent conductive layer 1 and the band gap Eg₂ (eV) of the p-type semiconductor layer 2 satisfy the relationship represented by the formula: Eg₁ > Eg₂. By satisfying this relationship, it is possible to reduce the optical loss in the transparent conductive layer 1. The electron affinity X₁ (eV) of the transparent conductive layer 1 and the electron affinity X₂ (eV) of the p-type semiconductor layer 2 satisfy the relationship represented by the formula: 0 ≤ (X₂ - X₁) < 0.5 (eV).

The material used for the transparent conductive layer 1 is not particularly limited, as long as it has the above-described characteristics and satisfies the above-described relationships. Specifically, for example, an oxide thin film including an oxide that contains two or more different group IIIb elements can be used. Alternatively, an oxide thin film including an oxide that contains a group IVb element and two or more different group IIIb elements can be used. More specifically, it is possible to use, for example, a thin film including (In₁₋ₓGaₓ)₂O₃, (In₁₋ₓAlₓ)₂O₃, (In₁₋ₓGaₓ)₂O₃:SnO₂ or (In₁₋ₓAlₓ)₂O₃:SnO₂ (where x is a numerical value satisfying the formula: 0 < x < 1). Particularly, an oxide including In, Ga, Sn and O (oxygen) is preferable. Such a transparent conductive layer 1 can be produced by, for example, sputtering using sintered materials of compounds with the above-described respective compositions as the target. In addition, the thickness of the transparent conductive layer 1 is not particularly limited, and may be in the range from 0.5 µm to 2 µm, for example.

By producing the solar cell 10 as described above, it is possible to provide a solar cell with a high conversion efficiency while omitting a window layer. Furthermore, it is possible to provide a solar cell that has been reduced in cost, since the window layer can be omitted.

The reasons why a high conversion efficiency can be achieved in the solar cell 10 shown in FIG. 1 are described below.

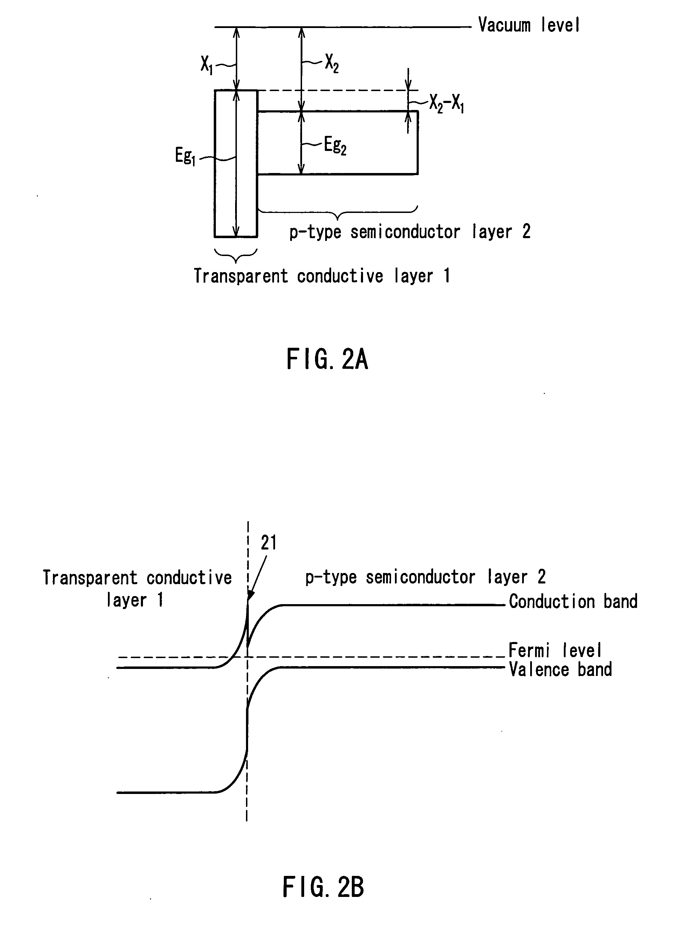

FIGS. 2A and 2B schematically show an example of a band profile of the solar cell 10 shown in FIG. 1. FIG. 2A shows a band profile without taking a junction into account, and FIG. 2B shows a band profile taking a junction into account.

When the electron affinity X₁ of the n-type transparent conductive layer 1 is smaller than the electron affinity X₂ of the p-type semiconductor layer 2 as shown in FIG. 2A, then the band profile after forming the junction is as shown in FIG. 2B. At the interface between the two layers, a spike 21 reflecting (X₂ - X₁), which is the electron affinity difference (conduction band energy difference), is formed in the conduction band. When a spike 21 is formed, the spike 21 serves as a barrier and suppresses the tunneling conduction of the electrons that have been injected into the transparent conductive layer 1 to the valence band of the p-type semiconductor layer 2. Therefore, it is possible to reduce leakage due to the tunneling current, without providing any window layer. That is, it is possible to suppress the reduction of the conversion efficiency of a solar cell, providing a solar cell with a high conversion efficiency.

Next, when the electron affinity difference (X₂ - X₁) between the two layers is 0.5 (eV) or more, the height of the spike 21 also is 0.5e V or more. When the spike 21 is too high as in this case, the spike 21 serves as a barrier when the carriers (electrons) that have been excited in the p-type semiconductor layer 2 by light absorption flow into the n-type transparent conductive layer 1. This results in a recombination of the carriers at the interface between the transparent conductive layer 1 and the p-type semiconductor layer 2, and the generated photovoltaic power (or photocurrent) may not be retrieved effectively. As described above, in order to obtain a high conversion efficiency in a solar cell of the present invention from which a window layer has been omitted, there is an optimal range of the electron affinity difference (conduction band energy difference) between the transparent conductive layer 1 and the p-type semiconductor layer 2. This range is represented by the formula: 0 ≤ (X₂ - X₁) < 0.5 (eV).

It is possible to control the values of Eg₁ and Eg₂, for example, by adjusting the composition of each layer. It is also possible to control the values of X₁, X₂ and (X₂ - X₁), for example, by adjusting the composition of each layer. Specific examples are described in the examples below.

In the following, other components of the solar cell shown in FIG. 1 are described.

The material used for the substrate 5 is not particularly limited, and any materials commonly used for solar cells can be used. Examples include substrates made of nonmetallic materials, such as a glass substrate and a polyimide substrate, and substrates made of metallic materials, such as an aluminum alloy substrate (e.g., a duralumin substrate), a stainless steel substrate and a titanium substrate. In addition, when a solar cell of the present invention is produced as an integrated solar cell including a plurality of series-connected unit cells formed on the substrate 5, it is necessary that at least the surface of the substrate 5 be insulating. For this reason, in the case of using a conductive substrate (e.g., a stainless steel substrate), it is necessary to either form an insulating layer on the surface of the substrate or perform a treatment to make the surface of the substrate insulating.

The material used for the lower electrode layer 4 is not particularly limited, as long as it has conductivity. Examples include metals and semiconductors that have a volume resistivity of 6 × 10⁶ Ω·cm or less. Specifically, Mo (molybdenum) can be used, for example. The shape of the lower electrode layer 4 is not particularly limited, and may be determined freely depending on the required shape of the solar cell 10. The same also applies to other layers, including the transparent conductive layer 1 and the p-type semiconductor layer 2. The thickness of the lower electrode layer 4 is in the range from about 0.1 µm to about 1 µm, for example.

The lower electrode layer 4 can be produced by any method commonly used for producing solar cells. In order to form the lower electrode layer 4 on the substrate 5, sputtering or vapor deposition can be used, for example.

The electrode 6 is an electrode for retrieving the electromotive force generated in the solar cell 10. The material used for the electrode 6 is not particularly limited, and may be any material commonly used for solar cells. For example, NiCr, Ag, Au or Al can be used.

The method of forming the electrode 6 is not particularly limited as long as the electrode 6 can be electrically connected to the transparent conductive layer 1, and any common method, including, for example, vapor deposition can be used.

### Embodiment 2

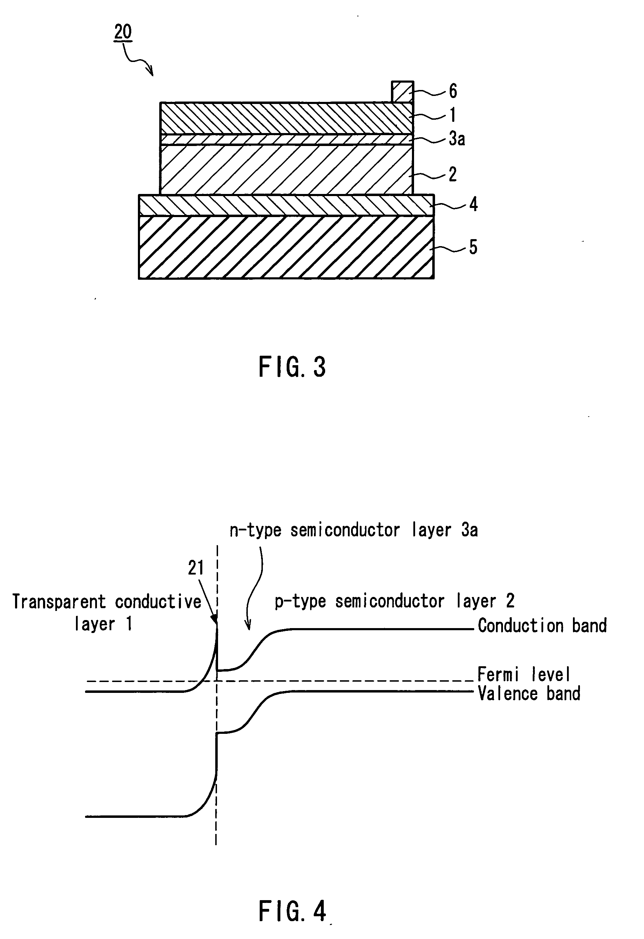

FIG. 3 shows another example of a solar cell of the present invention.

A solar cell 20 shown in FIG. 3 is different from the solar cell 10 shown in FIG. 1 in that it further includes an n-type semiconductor layer 3a disposed between the transparent conductive layer 1 and the p-type semiconductor layer 2. Specifically, the solar cell 20 shown in FIG. 3 includes a transparent conductive layer 1 (first layer) having translucency and conductivity, an n-type semiconductor layer 3a disposed adjacent to the transparent conductive layer 1 and a p-type semiconductor layer 2 disposed in such a manner that the n-type semiconductor layer 3a is sandwiched between the p-type semiconductor layer 2 and the transparent conductive layer 1. The transparent conductive layer 1 is disposed at the light incident side, and the n-type semiconductor layer 3a is disposed adjacent to the back side of the transparent conductive layer 1 (the side opposite to the light incident side). The p-type semiconductor layer 2 is disposed adjacent to the back side of the n-type semiconductor layer 3a. A junction is formed by the transparent conductive layer 1, the n-type semiconductor layer 3a and the p-type semiconductor layer 2 (i.e., the junction necessary to obtain photovoltaic power is made up of the transparent conductive layer 1, the n-type semiconductor layer 3a and the p-type semiconductor layer 2), so that the solar cell 20 can generate photovoltaic power with light incident from the side of the transparent conductive layer 1.

The p-type semiconductor layer 2 and the transparent conductive layer 1 may be the same as the p-type semiconductor layer 2 and the transparent conductive layer 1 of the solar cell 10 shown in FIG. 1.

The band gap Eg₃ (eV) and the electron affinity X₃ (eV) of the n-type semiconductor layer 3a are substantially equal to the band gap Eg₂ (eV) and the electron affinity X₂ (eV) of the p-type semiconductor layer 2, respectively. That is, Eg₃ = Eg₂ and X₃ = X₂ are substantially satisfied. In addition, the carrier density of the transparent conductive layer 1 is 10¹⁹/cm³ or more. Accordingly, a junction can be formed by the transparent conductive layer 1, the n-type semiconductor layer 3a and the p-type semiconductor layer 2. It should be noted that "substantially equal" described in this specification means that there may be minor differences between the two, to an extent that there are no difference in the material characteristics. For example, when the absolute value of the difference between Eg₂ and Eg₃ is 0.05 eV or less, it can be said that they are substantially equal. Similarly, for example, when the absolute value of the difference between X₂ and X₃ is 0.05 eV or less, it can be said that they are substantially equal.

In the case of the solar cell 20 shown in FIG. 3, the band gap Eg₃ (eV) of the n-type semiconductor layer 3a and the band gap Eg₁ (eV) of the transparent conductive layer 1 satisfy the relationship represented by the formula: Eg₁ > Eg₃. By satisfying this relationship, it is possible to reduce the optical loss in the transparent conductive layer 1. The electron affinity X₁ (eV) of the transparent conductive layer 1 and the electron affinity X₃ (eV) of the n-type semiconductor layer 3a satisfy the relationship represented by the formula: 0 ≤ (X₃ - X₁) < 0.5 (eV). The thickness of the n-type semiconductor layer 3a is not particularly limited, and may be, for example, in the range from 10 nm to 100 nm.

The material used for the n-type semiconductor layer 3a is not particularly limited, as long as it has the above-described characteristics and satisfies the above-described relationships. Specifically, it is possible to use, for example, a semiconductor thin film with a chalcopyrite structure containing a group Ib element, a group IIIb element and a group VIb element that is doped with a group IIa element or a group IIb element. Particularly, it is preferable to use a semiconductor thin film with a chalcopyrite structure containing a group Ib element, a group IIIb element and a group VIb element that is doped with both a group IIa element and a group IIb element. Here, the group IIa element and the group IIb element to be doped are not particularly limited, and may be, for example, at least one selected from the group consisting of Mg, Ca and Zn. More specifically, for example, a Cu(In, Ga)Se₂ film containing Zn and Mg or a Cu(In, Ga)Se₂ film containing Zn and Ca can be used. Thus, it is possible to provide a solar cell with excellent power generation characteristics such as conversion efficiency.

Such an n-type semiconductor layer 3a can be formed on the surface of the p-type semiconductor layer 2, for example, by vapor depositing and thermally diffusing additional elements (e.g., Zn and Mg, or Zn and Ca) on the surface of the p-type semiconductor layer 2, after forming the p-type semiconductor layer 2. Alternatively, it can be formed by performing sputtering on the surface of the p-type semiconductor layer 2, after forming the p-type semiconductor layer 2. It also can be formed by diffusing additional elements on the surface of the p-type semiconductor layer 2 by immersing the p-type semiconductor layer 2 in a solution containing the additional elements.

By producing such a solar cell 20, it is possible to provide a solar cell with a high conversion efficiency while omitting a window layer. Furthermore, since a window layer can be omitted, it is possible to provide a solar cell that has been reduced in cost.

The reasons why a high conversion efficiency can be achieved in the solar cell 20 shown in FIG. 3 are described below.

FIG. 4 schematically shows an example of a band profile of the solar cell 20 show in FIG. 3 (the areas of the transparent conductive layer 1, the n-type semiconductor layer 3a and the p-type semiconductor layer 2 are shown). A junction is made up of the transparent conductive layer 1, the n-type semiconductor layer 3a and the p-type semiconductor layer 2, and a p-n junction is formed by the n-type semiconductor layer 3a and the p-type semiconductor layer 2.

In the solar cell 20, as in the case of the solar cell 10 shown in FIG. 1, a spike 21 is formed in the conduction band at the interface between the transparent conductive layer 1 and the semiconductor layer (n-type semiconductor layer 3a) adjacent to the transparent conductive layer 1. When a spike 21 is formed, the spike 21 serves as a barrier and suppresses the tunneling conduction of the electrons that have been injected into the transparent conductive layer 1 to the valence band of the p-type semiconductor layer 2. That is, it is possible to reduce leakage due to the tunneling current from the transparent conductive layer 1 to the p-type semiconductor layer 2. Furthermore, the presence of the n-type semiconductor layer 3a in the solar cell 20 can reduce the probability of the tunneling conduction from the conduction band of the transparent conductive layer 1 to the valence band of the p-type semiconductor layer 2 more successfully.

As described in Embodiment 1 above, when the spike 21 is too high (e.g., the electron affinity difference (X₃ - X₁) between the transparent conductive layer 1 and the n-type semiconductor layer 3a is 0.5 eV or more), there is the possibility that the spike 21 serves as a barrier for the photoexcited carriers. Therefore, there is an optimal range of the electron affinity difference (conduction band energy difference) between the transparent conductive layer 1 and the n-type semiconductor layer 3a. This range is represented by the formula: 0 ≤ (X₃ - X₁) < 0.5e V.

It is possible to control the values of Eg₃ and X₃, for example, by adjusting the composition of the n-type semiconductor layer 3a. The components of the solar cell 20 shown in FIG. 3, such as the substrate 5 and the lower electrode layer 4, may be the same as the components of the solar cell 10 shown in FIG. 1.

### Embodiments 3

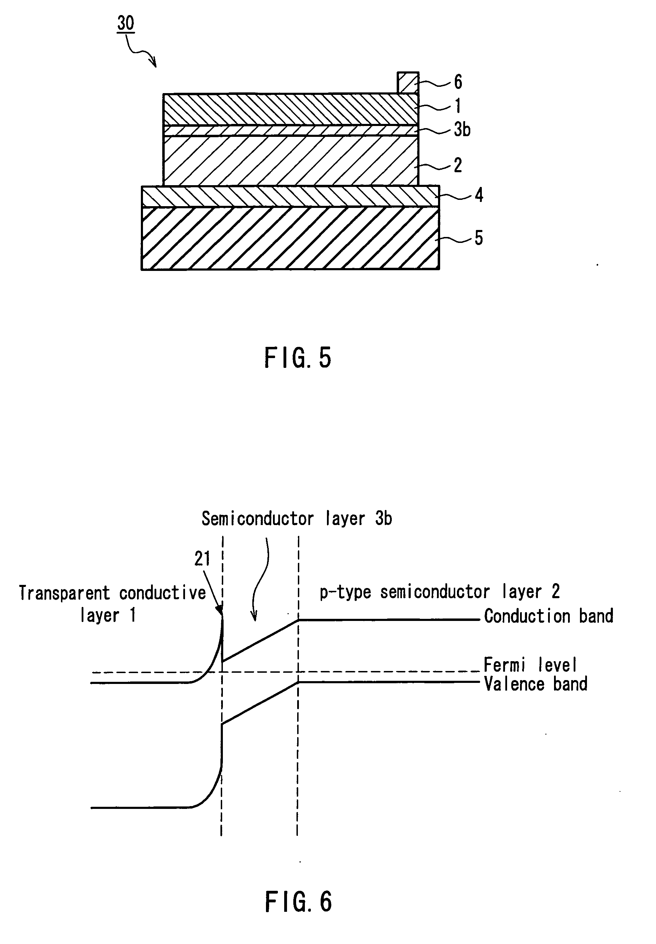

FIG. 5 shows yet another example of a solar cell of the present invention.

A solar cell 30 shown in FIG. 5 is different from the solar cell 10 shown in FIG. 1 in that it further includes a semiconductor layer 3b disposed between the transparent conductive layer 1 and the p-type semiconductor layer 2. Specifically, the solar cell 30 shown in FIG. 5 includes a transparent conductive layer 1 (first layer) having translucency and conductivity, a semiconductor layer 3b disposed adjacent to the transparent conductive layer 1 and a p-type semiconductor layer 2 disposed in such a manner that the semiconductor layer 3b is sandwiched between the p-type semiconductor layer 2 and the transparent conductive layer 1. The transparent conductive layer 1 is disposed at the light incident side, and the semiconductor layer 3b is disposed adjacent to the back side of the transparent conductive layer 1 (the side opposite to the light incident side). The p-type semiconductor layer 2 is disposed adjacent to the back side of the semiconductor layer 3b. A junction is formed by the transparent conductive layer 1, the semiconductor layer 3b and the p-type semiconductor layer 2 (i.e., the junction necessary to obtain photovoltaic power is made up of the transparent conductive layer 1, the semiconductor layer 3b and the p-type semiconductor layer 2), so that the solar cell 30 can generate photovoltaic power with light incident from the side of the transparent conductive layer 1.

The p-type semiconductor layer 2 and the transparent conductive layer 1 may be the same as the p-type semiconductor layer 2 and the transparent conductive layer 1 of the solar cell 10 shown in FIG. 1.

The band gap Eg₄ (eV) and the electron affinity X₄ (eV) of the semiconductor layer 3b are substantially equal to the band gap Eg₂ (eV) and the electron affinity X₂ (eV) of the p-type semiconductor layer 2, respectively. That is, Eg₄ = Eg₂ and X₄ = X₂ are substantially satisfied. In addition, the carrier density of the transparent conductive layer 1 is 10¹⁹/cm³ or more. Thus, it is possible to form a junction between the transparent conductive layer 1, the semiconductor layer 3b and the p-type semiconductor layer 2.

In the case of the solar cell 30 shown in FIG. 5, the band gap Eg₄ (eV) of the semiconductor layer 3b and the band gap Eg₁ (eV) of the transparent conductive layer 1 satisfy the relationship represented by the formula: Eg₁ > Eg₄. By satisfying this relationship, it is possible to reduce optical loss in the transparent conductive layer 1. Additionally, the electron affinity X₁ (eV) of the transparent conductive layer 1 and the electron affinity X₄ (eV) of the semiconductor layer 3b satisfy the relationship represented by the formula: 0 ≤ (X₄ - X₁) < 0.5 (eV).

Here, the carrier density N₄ (cm-³) of the semiconductor layer 3b and the carrier density N₂ (cm⁻³) of the p-type semiconductor layer 2 satisfy the relationship represented by the formula: N₄ < N₂. The carrier density N₄ of the semiconductor layer 3b may be, for example, 10¹⁵/cm³ or less, preferably 10¹²/cm³ or more and 10¹⁵/cm³ or less. In such a range, the semiconductor layer 3b becomes a semiconductor layer with a high resistivity (e.g., having a volume resistivity in the range from about 10³ Ω·cm to about 10⁶ Ω·cm). The carrier density N₂ of the p-type semiconductor layer 2 is, for example, in the range of 10¹⁵/cm³ or more and 10¹⁷/cm³ or less.

The material used for the semiconductor layer 3b is not particularly limited, as long as it has the above-described characteristics and satisfies the above-described relationships. Specifically, for example, it is possible to use a semiconductor thin film with a chalcopyrite structure containing a group Ib element, a group IIIb element and a group VIb element that is doped with a group IIa element or a group IIb element. Here, the group IIa element and group IIb element that are doped are not particularly limited, and may be, for example, at least one selected from the group consisting of Mg, Ca and Zn. More specifically, for example, a Cu(In, Ga)Se₂ film containing Zn or a Cu(In, Ga)Se₂ film containing Mg can be used. Thus, it is possible to provide a solar cell with excellent power generation characteristics such as conversion efficiency.

Such a semiconductor layer 3b can be produced on the surface of the p-type semiconductor layer 2, for example, by thermally diffusing additional elements (e.g., Zn and Mg) on the surface of the p-type semiconductor layer 2 by vapor deposition, after forming the p-type semiconductor layer 2. Alternatively, it can be formed by performing sputtering on the surface of the p-type semiconductor layer 2, after forming the p-type semiconductor layer 2. It also can be formed by diffusing additional elements on the surface of the p-type semiconductor layer 2 by immersing the p-type semiconductor layer 2 in a solution containing the additional elements.

By producing such a solar cell 30, it is possible to provide a solar cell with a high conversion efficiency while omitting a window layer. Furthermore, since a window layer can be omitted, it is possible to provide a solar cell that has been reduced in cost.

The reasons why a high conversion efficiency can be achieved in the solar cell 30 shown in FIG. 5 are described below.

FIG. 6 schematically shows an example of a band profile of the solar cell 30 shown in FIG. 5 (the areas of the transparent conductive layer 1, the semiconductor layer 3b and the p-type semiconductor layer 2 are shown). As described above, since the carrier density of the semiconductor layer 3b is low, an internal electric field occurs in the entire semiconductor layer 3b and the band is thus bent. For example, if the semiconductor layer 3b is produced as a high resistivity layer, a p-i-n junction can be formed by the p-type semiconductor layer 2, the semiconductor layer 3b with a high resistivity (i layer) and the transparent conductive layer 1 (especially when it is n-type). Here, the semiconductor layer 3b has a high resistivity, so that the bend of the band hardly changes whether its conduction type (substantially nearly intrinsic conduction type) is n-type or p-type. In this case also, a spike 21 is formed in the conduction band at the interface between the transparent conductive layer 1 and the semiconductor layer 3b disposed adjacent to the transparent conductive layer 1, as in the case of the solar cell 10. When a spike 21 is formed, the spike 21 serves as a barrier and suppresses the tunneling conduction of the electrons that have been injected into the transparent conductive layer 1 to the valence band of the p-type semiconductor layer 2. That is, it is possible to reduce leakage due to the tunneling current from the transparent conductive layer 1 to the p-type semiconductor layer 2.

Furthermore, the presence of the high resistivity semiconductor layer 3b in the solar cell 30 can reduce the probability of the tunneling conduction from the conduction band of the transparent conductive layer 1 to the valence band of the p-type semiconductor layer 2 more successfully. Here, when the thickness of the semiconductor layer 3b is sufficiently large (e.g., in the range from 10 nm to 1 µm, preferably in the range from 100 nm to 500 nm), the probability of the tunneling conduction can be reduced even more successfully, and a leakage current can be reduced further.

As described in Embodiment 1 above, when the spike 21 is too high (e.g., the electron affinity difference (X₄ - X₁) between the transparent conductive layer 1 and the semiconductor layer 3b is 0.5e V or more), there is the possibility that the spike 21 serves as a barrier for photoexcited carriers. Therefore, there is an optimal range of the electron affinity difference (conduction band energy difference) between the transparent conductive layer 1 and the semiconductor layer 3b. This range is represented by the formula: 0 ≤ (X₄-X₁) < 0.5 eV.

In addition, the values of Eg₄ and X₄ can be controlled, for example, by adjusting the composition or the carrier density of the semiconductor layer 3b. The components of the solar cell 30 shown in FIG 5, such as the substrate 5, the lower electrode layer 4 and the electrode 6, may be the same as those of the solar cell 10 shown in FIG. 1.

### Examples

Hereinafter, the present invention is described in further detail according to examples. However, the present invention is not limited to the following examples.

### Example 1

In Example 1, a solar cell 10 as shown in FIG. 1 was produced, and its power generation characteristics were evaluated.

First, a glass substrate was prepared as a substrate 5. Then, a Mo film (film thickness 0.5 µm) was formed as a lower electrode layer 4 on the glass substrate. The Mo film was formed by sputtering in an Ar gas atmosphere (pressure 1 Pa), using Mo as a target.

Next, a Cu(In, Ga)Se₂ film (CIGS film: film thickness 2 µm) was formed as a p-type semiconductor layer 2 on the Mo film by vacuum evaporation. Specifically, Cu, In, Ga and Se were evaporated from independent evaporation sources at a substrate temperature of 550°C.

Next, a (In₁₋ₓGaₓ)₂O₃ film (film thickness 1 µm) was formed as a transparent conductive layer 1 on the Cu(In, Ga)Se₂ film by sputtering. Specifically, the sputtering was performed by applying high frequency independently to two different sintered materials, namely, In₂O₃ and Ga₂O₃, in an Ar gas atmosphere (pressure 0.3 Pa) (two-target sputtering). Here, the composition ratio of In and Ga was controlled by adjusting the power applied to the above-described two different sintered targets.

Then, a laminated film of NiCr and Al was formed as an electrode 6 on the (In₁₋ₓGaₓ)₂O₃ film by electron beam evaporation. Thus, a solar cell 10 as shown in FIG. 1 was produced.

The (In₁₋ₓGaₓ)₂O₃ film serving as the transparent conductive layer 1 exhibited an n-type conductivity with a low resistivity (carrier density 5 × 10²⁰/cm³) due to oxygen deficiency.

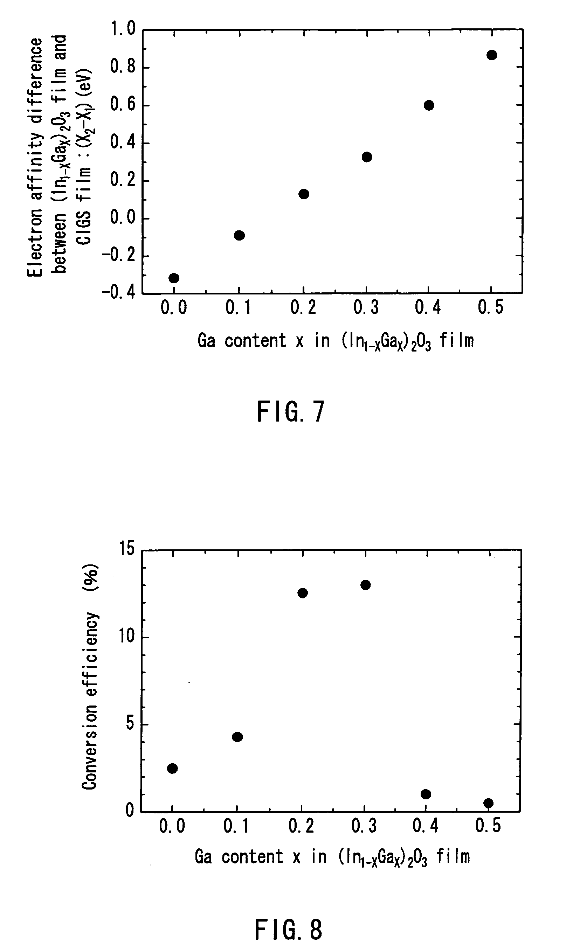

FIG. 7 shows the relationship between (X₂ - X₁), which is the electron affinity difference (conduction band energy difference) between the (In₁₋ₓGaₓ)₂O₃ film and the GIGS film, and the Ga content x in the (In₁₋ₓGaₓ)₂O₃ film. The electron affinity difference was calculated by measuring the valence band difference by X-ray photoelectron spectroscopy (XPS), as well as by measuring the band gap based on the measurement of the light transmittance or reflectance, or the spectral sensitivity of the solar cell.

It should be noted that the Ga content x is a value representing the proportion of Ga in the group IIIb elements in the (In₁₋ₓGaₓ)₂O₃ film.

As shown in FIG. 7, the electron affinity difference increased substantially linearly with an increase in the Ga concentration for the range from x = 0 to x = 0.3. In addition, the gradient of the increase of the electron affinity difference became steeper for the range of x ≥ 0.4. The results shown in FIG. 7 proved that the electron affinity difference between the (In₁₋ₓGaₓ)₂O₃ film and the CIGS film could be controlled by controlling the Ga content x in the (In₁₋ₓGaₓ)₂O₃ film.

Next, FIG. 8 shows the relationship between the Ga content x in the group IIIb elements in the (In₁₋ₓGaₓ)₂O₃ film serving as the transparent conductive layer and the conversion efficiency of the solar cell. The conversion efficiency was determined by measuring the current-voltage characteristics under the irradiation of simulated sunlight (AM (AirMass) 1.5, 100 mW/cm²). A high conversion efficiency of 12% or more was obtained when the Ga content x in the group IIIb elements was in the range from about 0.2 to about 0.3.

As shown in FIG. 7, the electron affinity difference between the (In₁₋ₓGaₓ)₂O₃ film and the CIGS film was in the range from 0 eV to less than 0.5 eV for the above-described range of the Ga content x (x is about 0.2 to about 0.3). Specifically, the electron affinity difference was 0.13 eV when the Ga content x was 0.2, and the electron affinity difference was 0.33 eV when the Ga content x was 0.3.

According to Example 1, it was found that the electron affinity difference between the (In₁₋ₓGaₓ)₂O₃ film and the CIGS film could be controlled by controlling the Ga content x in the (In₁₋ₓGaₓ)₂O₃ film. It also was found that a high conversion efficiency could be achieved when the electron affinity difference (X₂ - X₁) between the (In₁₋ₓGaₓ)₂O₃ film and the CIGS film was in the range represented by the formula: 0 ≤ (X₂ - X₁) < 0.5 (eV). Although the (In₁₋ₓGaₓ)₂O₃ film was used as the transparent conductive layer in Example 1, similar results also were obtained when a (In₁₋ₓAlₓ)₂O₃ film was used.

### Example 2

In Example 2, a solar cell 20 as shown in FIG. 3 was produced, and its power generation characteristics were evaluated.

First, the same glass substrate as that of Example 1 was prepared as a substrate 5, and a Mo film (lower electrode layer 4) and a Cu(In, Ga)Se₂ film (p-type semiconductor layer 2) were formed on the glass substrate in the same manner as in Example 1.

Next, Zn and Mg were simultaneously vapor deposited on and thermally diffused into the Cu(In, Ga)Se₂ film at a substrate temperature of 400°C. This step formed a Cu(In, Ga)Se₂:Zn, Mg film (CIGS:Zn, Mg film) doped with Zn and Mg as an n-type semiconductor layer 3a on the surface of the Cu(In, Ga)Se₂ film. The thickness of the CIGS:Zn,Mg film was 50 nm.

Then, a (In₁₋ₓGaₓ)₂O₃:SnO₂ film (film thickness 0.3 µm) was formed as a transparent conductive layer 1 on the CIGS:Zn, Mg film by sputtering. Specifically, the sputtering was performed by applying high frequency independently to two different sintered materials, namely, In₂O₃:SnO₂ containing 10 wt% of SnO₂ and Ga₂O₃, in a mixed gas atmosphere of Ar and O₂ (5 vol% oxygen) (two target sputtering). Here, the composition ratio of In an Ga was controlled by adjusting the power applied to the above-described two different sintered targets. Then, an electrode 6 was formed in the same manner as in Example 1, and a solar cell 20 as shown in FIG. 3 was produced.

The carrier density of the (In₁₋ₓGaₓ)₂O₃:SnO₂ film serving as the transparent conductive layer 1 was 10²¹/cm³ or more, so that the film was a low resistivity transparent conductive layer. The band gap Eg₂ of the Cu(In, Ga)Se₂ film serving as the p-type semiconductor layer 2 was substantially equal to Eg₃, and the electron affinity X₂ of the Cu(In, Ga)Se₂ film serving as the p-type semiconductor layer 2 was substantially equal to the electron affinity X₃ of the CIGS:Zn, Mg film serving as the n-type semiconductor layer 3a. In addition, the values of the band gap and the electron affinity difference of each layer were determined in the same manner as in Example 1.

The relationship between (X₃ - X₁), which is the electron affinity difference (conduction band energy difference) between the (In₁₋ₓGaₓ)₂O₃:SnO₂ film serving as the transparent conductive layer and the CIGS:Zn, Mg film serving as the n-type semiconductor layer, and the Ga content x in the (In₁₋ₓGaₓ)₂O₃:SnO₂ film was similar to the results shown in FIG. 7, and no change was measured in the electron affinity as a result of adding SnO₂ to the transparent conductive layer 1. That is, similarly to Example 1, it was found that the electron affinity difference between the (In₁₋ₓGaₓ)₂O₃:SnO₂ film and the CIGS film could be controlled by controlling the Ga content x in the (In₁₋ₓGaₓ)₂O₃:SnO₂ film.

The relationship between the Ga content x in the group IIIb elements in the (In₁₋ₓGaₓ)₂O₃:SnO₂ film serving as the transparent conductive layer and the conversion efficiency of the solar cell was calculated in the same manner as in Example 1, and results similar to FIG. 8 were obtained for the conversion efficiency. Specifically, a high conversion efficiency of 14% or more was obtained for the range where the Ga content x in the group IIIb elements was from about 0.2 to about 0.3. Similarly to Example 1, the range where the Ga content x is from about 0.2 to about 0.3 is the range where the difference (X₃ - X₁) between the electron affinity X₁ of the (In₁₋ₓGaₓ)₂O₃:SnO₂ film serving as the transparent conductive layer 1 and the electron affinity X₃ of the CIGS:Zn, Mg film serving as the n-type semiconductor layer 3a satisfies the formula: 0 ≤ (X₃ - X₁) < 0.5 (eV).

A comparison between the solar cell evaluated in Example 2 and the solar cell evaluated in Example 1 showed that the solar cell evaluated in Example 2 had a higher conversion efficiency when the Ga content x was the same for the two cells. Presumably, this is because the presence of the CIGS:Zn, Mg film (n-type semiconductor layer 3a) reduced a leakage current from the transparent conductive layer 1 to the p-type semiconductor layer 2 more successfully.

According to Example 2, it was found that the electron affinity difference between the (In₁₋ₓGaₓ)₂O₃:SnO₂ film and the CIGS:Zn, Mg film (n-type CIGS film) could be controlled by controlling the Ga content x in the (In₁₋ₓGaₓ)₂O₃:SnO₂ film. Furthermore, it was found that a high conversion efficiency could be achieved when the electron affinity difference (X₃ - X₁) between the (In₁₋ₓGaₓ)₂O₃:SnO₂ film and the CIGS film was in the range represented by the formula: 0 ≤ (X₃ - X₁) < 0.5 (eV). Although the CIGS:Zn, Mg film doped with Zn and Mg was used as the n-type semiconductor layer 3a in Example 2, similar results were obtained when a CIGS:Zn, Ca film doped with Zn and Ca was used.

### Example 3

In Example 3, a solar cell 30 shown in FIG. 5 was produced, and its power generation characteristics were evaluated.

First, the same glass substrate as that of Example 1 was prepared as a substrate 5, and a Mo film (lower electrode layer 4) and a Cu(In, Ga)Se₂ film (p-type semiconductor layer 2) were formed on the glass substrate in the same manner as in Example 1.

Next, Zn was thermally diffused into the Cu(In, Ga)Se₂ film by evaporation at a substrate temperature of 400°C. This step formed a Cu(In, Ga)Se₂:Zn film (CIGS:Zn film) doped with Zn as a semiconductor layer 3b on the surface of the Cu(In, Ga)Se₂ film. Here, the thickness of the CIGS:Zn film was controlled by varying the evaporation time of Zn.

Next, a (In_{0.7}Ga_{0.3})₂O₃:SnO₂ film (film thinness 0.3 µm) was formed as a transparent conductive layer 1 on the CIGS:Zn film by DC sputtering. Specifically, the sputtering was performed by applying a direct current to a sintered material of (In_{0.7}Ga_{0.3})₂O₃:SnO₂ containing 10 wt% of SnO₂, in a mixed gas atmosphere of Ar and O₂ (5 vol% oxygen). Next, an electrode 6 was produced in the same manner as in Example 1, and a solar cell 30 as shown in FIG. 5 was produced.

The carrier density of the (In_{0.7}Ga_{0.3})₂O₃:SnO₂ film serving as the transparent conductive layer 1 was 10²¹/cm³ or more, so that the film was a low resistivity transparent conductive layer. The band gap Eg₁ of the (In_{0.7}Ga_{0.3})₂O₃:SnO₂ film serving as the transparent conductive layer 1 and the band gap Eg₄ of the CIGS:Zn film serving as the semiconductor layer 3b satisfied the relationship Eg₁ > Eg₄. The band gap Eg₂ of the Cu(In, Ga)Se₂ film serving as the p-type semiconductor layer 2 was substantially equal to Eg₄, and the electron affinity X₂ of the Cu(In, Ga)Se₂ film serving as the p-type semiconductor layer 2 was substantially equal to the electron affinity X₄ of the CIGS:Zn film serving as the semiconductor layer 3b. The electron affinity difference (X₄ - X₁) between the (In_{0.7}Ga_{0.3})₂O₃:SnO₂ film and the CIGS:Zn film was 0.33 (eV). The values of the band gap and the electron affinity difference of each layer were calculated in the same manner as in Example 1.

In Example 3, solar cells with varied thicknesses of the CIGS:Zn film from 10 nm to 500 nm were produced by changing the evaporation time of Zn. Here, the carrier densities of the CIGS film serving as the p-type semiconductor layer 2 and the CIGS:Zn film serving as the semiconductor layer 3b were 10¹⁶/cm³ and 10¹⁴/cm³, respectively, which confirmed that the CIGS:Zn film had a higher resistivity.

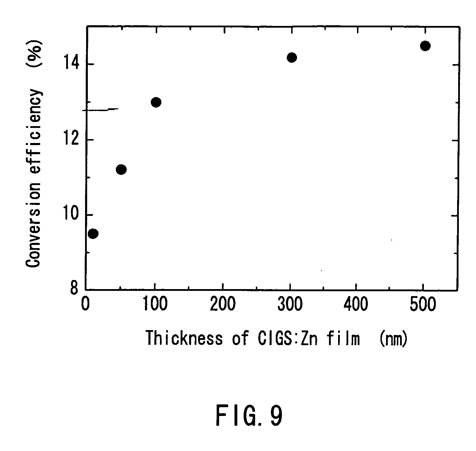

FIG. 9 shows the change in the conversion efficiency of the solar cell with respect to the thickness of the CIGS:Zn film. The conversion efficiency was measured in the same manner as in Example 1. As shown in FIG. 9, the conversion efficiency improved with an increase in the thickness of the CIGS:Zn film. In particular, a high conversion efficiency of 13% or more was achieved when the thickness of the CIGS:Zn film was 100 nm or more. Presumably, this is because increasing the thickness of the CIGS:Zn film, which was a semiconductor layer with a low carrier density and a high resistivity, reduced a leakage current from the transparent conductive layer 1 to the p-type semiconductor layer 2, more successfully.

According to Example 3, it was found that a solar cell with a high conversion efficiency could be obtained by including the CIGS:Zn film (semiconductor layer 3b). It also was found that a solar cell with a higher conversion efficiency could be obtained by controlling the thickness of the CIGS:Zn film (semiconductor layer 3b). Although the CIGS:Zn film was used as the semiconductor layer 3b in Example 3, similar results were obtained when a CIGS:Mg film doped with Mg or a CIGS:Ca film doped with Ca was used.

As described above, according to the present invention, it is possible to obtain a solar cell with a high conversion efficiency while omitting a window layer, by specifying the relationship with regard to the band gap and the electron affinity between the transparent conductive layer 1 with the p-type semiconductor layer 2 (or with the n-type semiconductor layer 3a, or with the semiconductor layer 3b). Presumably, this is because leakage due to the tunneling current flowing between the transparent conductive layer and the p-type semiconductor layer (light absorption layer) can be reduced and a band profile that does not become a barrier for photocarriers can be realized.

Further, the band gap and the electron affinity of the transparent conductive layer 1 in a solar cell of the present invention can be controlled freely by changing the composition ratio of one or a plurality of different group IIIb elements. Accordingly, it is possible to obtain a solar cell with a high conversion efficiency.

## Claims

1. A solar cell comprising: a first layer having translucency and conductivity; and a p-type semiconductor layer disposed adjacent to the first layer, a junction being formed by the first layer and the p-type semiconductor layer, wherein
the p-type semiconductor layer comprises a semiconductor with a chalcopyrite structure containing a group Ib element, a group IIIb element and a group VIb element,
the first layer has a carrier density of 10¹⁹/cm³ or more,
a band gap Eg₁ (eV) of the first layer and a band gap Eg₂ (eV) of the p-type semiconductor layer satisfy a relationship represented by the formula: Eg₁ > Eg₂, and
an electron affinity X₁ (eV) of the first layer and an electron affinity X₂ (eV) of the p-type semiconductor layer satisfy a relationship represented by the formula: 0 ≤ (X₂ - X₁) < 0.5.

2. A solar cell comprising: a first layer having translucency and conductivity; an n-type semiconductor layer disposed adjacent to the first layer; and a p-type semiconductor layer disposed in such a manner that the n-type semiconductor layer is sandwiched between the p-type semiconductor layer and the first layer, a junction being formed by the first layer, the n-type semiconductor layer and the p-type semiconductor layer, wherein
the p-type semiconductor layer comprises a semiconductor with a chalcopyrite structure containing a group Ib element, a group IIIb element and a group VIb element,
the first layer has a carrier density of 10¹⁹/cm³ or more,
a band gap Eg₁ (eV) of the first layer and a band gap Eg₃ (eV) of the n-type semiconductor layer satisfy a relationship represented by the formula: Eg₁ > Eg₃,
an electron affinity X₁ (eV) of the first layer and an electron affinity X₃ (eV) of the n-type semiconductor layer satisfy a relationship represented by the formula: 0 ≤ (X₃ - X₁) < 0.5,
a band gap Eg₂ (eV) of the p-type semiconductor layer is substantially equal to the Eg₃, and
an electron affinity X₂ (eV) of the p-type semiconductor layer is substantially equal to the X₃.

3. The solar cell according to claim 2,
wherein the n-type semiconductor layer comprises a semiconductor with a chalcopyrite structure containing a group Ib element, a group IIIb element and a group VIb element to which at least one selected from the group consisting of Mg, Ca and Zn is added.

4. A solar cell comprising: a first layer having translucency and conductivity; a semiconductor layer disposed adjacent to the first layer; and a p-type semiconductor layer disposed in such a manner that the semiconductor layer is sandwiched between the p-type semiconductor layer and the first layer, a junction being formed by the first layer, the semiconductor layer and the p-type semiconductor layer, wherein
the p-type semiconductor layer comprises a semiconductor with a chalcopyrite structure containing a group Ib element, a group IIIb element and a group VIb element,
the first layer has a carrier density of 10¹⁹/cm³ or more,
a band gap Eg₁ (eV) of the first layer and a band gap Eg₄ (eV) of the semiconductor layer satisfy a relationship represented by the formula: Eg₁ > Eg₄,
an electron affinity X₁ (eV) of the first layer and an electron affinity X₄ (eV) of the semiconductor layer satisfy a relationship represented by the formula: 0 ≤ (X₄ - X₁) < 0.5,
a band gap Eg₂ (eV) of the p-type semiconductor layer is substantially equal to the Eg₄,
an electron affinity X₂ (eV) of the p-type semiconductor layer is substantially equal to the X₄, and
a carrier density N₂ (cm⁻³) of the p-type semiconductor layer and a carrier density N₄ (cm⁻³) of the semiconductor layer satisfy a relationship represented by the formula: N₄ < N₂.

5. The solar cell according to claim 4,
wherein the semiconductor layer comprises a semiconductor with a chalcopyrite structure containing a group Ib element, a group IIIb element and a group VIb element to which at least one selected from the group consisting of Mg, Ca and Zn is added.

6. The solar cell according to claim 4,
wherein the semiconductor layer has a thickness in a range from 10 nm to 1 µm.

7. The solar cell according to claim 4,
wherein a carrier density N₄ of the semiconductor layer is 10¹⁵/cm³ or less.

8. The solar cell according to any one of claims 1, 2 and 4,
wherein the first layer comprises an oxide containing two or more different group IIIb elements.

9. The solar cell according to any one of claims 1, 2 and 4,
wherein the first layer comprises an oxide containing a group IVb element and two or more different group IIIb elements.

10. The solar cell according to claim 9,
wherein the oxide comprises In, Ga, Sn and O.
